(19) Europäisches Patentamt

European Patent Office

Office européen des brevets

(11) **EP 4 768 978 A1**

(12) **EUROPEAN PATENT APPLICATION**

(43) Date of publication:
**01.07.2026 Bulletin 2026/27**

(21) Application number: **25208700.2**

(22) Date of filing: **14.10.2025**

(51) International Patent Classification (IPC):
**G01R 33/00** $^{(2006.01)}$        **G01R 33/09** $^{(2006.01)}$

(52) Cooperative Patent Classification (CPC):
**G01R 33/09; G01R 33/0017; G01R 33/0023;
G01R 33/0029; G01R 33/072; G01R 33/091;
G01R 33/093; G01R 33/098**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **27.12.2024 US 202419003034**

(71) Applicant: **Allegro MicroSystems, LLC
Manchester, NH 03103-3353 (US)**

(72) Inventors:
• **FUENTES, Leandro
1414 Caba (AR)**
• **CUNEO, Javier
1646 Buenos Aires (AR)**
• **UBERTI, Bruno Luis
C1425 Ciudad Autonoma de Buenos Aires (AR)**
• **RIVAS, Manuel
1425 Ciudad de Buenos Aires (AR)**

(74) Representative: **South, Nicholas Geoffrey et al
Venner Shipley LLP
TIDE Bankside
8 Emerson Street
London SE1 9DU (GB)**

(54) **MAGNETORESISTANCE COMPENSATION SYSTEM AND METHOD**

(57)    A sensor comprising: a sensing bridge including a first leg and a second leg, the first leg including a first magnetoresistance (MR) element that is coupled to a second MR element via a first transistor, the second leg including a third MR element that is coupled to a fourth MR element via a second transistor; a frontend circuit having a first input and a second input, the first input being coupled to the first leg, and the second input being coupled to the second leg; and a first resistive digital-to-analog converter (R-DAC) that is coupled to at least the first leg, the first R-DAC being arranged to receive a first trim code and modify a first resistance of the first leg based on the first trim code.

FIG. 2

EP 4 768 978 A1

**Description**

BACKGROUND

As is known, sensors are used to perform various functions in a variety of applications. Some sensors include one or more electromagnetic flux sensing elements, such as a Hall effect element, a magnetoresistive element, or a receiving coil to sense an electromagnetic flux associated with proximity or motion of a target object. Sensor integrated circuits are widely used in automobile control systems and other safety-critical applications. There are a variety of specifications that set forth requirements related to permissible sensor quality levels, failure rates, and overall functional safety.

SUMMARY

According to aspects of the disclosure, a sensor is provided comprising: a sensing bridge including a first leg and a second leg, the first leg including a first magnetoresistance (MR) element that is coupled to a second MR element via a first transistor, the second leg including a third MR element that is coupled to a fourth MR element via a second transistor; a frontend circuit having a first input and a second input, the first input being coupled to the first leg, and the second input being coupled to the second leg; and a first resistive digital-to-analog converter (R-DAC) that is coupled to at least the first leg, the first R-DAC being arranged to receive a first trim code and modify a first resistance of the first leg based on the first trim code.

According to aspects of the disclosure, a sensor is provided comprising: a sensing bridge including a first leg and a second leg, the first leg including a first switching circuitry, a first transistor, a first magnetoresistance (MR) element, and a second MR element that is coupled to the first MR element via the first transistor, the second leg including a third MR element that coupled to a fourth MR element via a second transistor; and a frontend circuit having a first input and a second input, the first input being coupled to the first leg, and the second input being coupled to the second leg, wherein the first MR element includes a plurality of first tap points, the plurality of first tap points including a pair of first end tap points and one or more first intermediate tap points; wherein one of the first end tap points is coupled to one of a power source or ground, and the other one of the first end tap points is coupled to the other one of the power source and ground, wherein the first switching circuitry includes a plurality of switches, each of the switches being configured to toggle a different one of the plurality of first tap points between being coupled to the frontend circuit and being disconnected from the frontend circuit, and wherein the first switching circuitry is configured to receive a first trim code and adjust a resistance of the first MR element that is sensed at the frontend circuit based on the first trim code.

BRIEF DESCRIPTION OF THE DRAWINGS

The foregoing features may be more fully understood from the following description of the drawings in which:

FIG. 1 is a diagram of an example of a sensor, according to the prior art;
FIG. 2 is a diagram of an example of a sensor, according to aspects of the disclosure;
FIG. 3 is a diagram of an example of resistive digital-to-analog converter (R-DAC), according to aspects of the disclosure;
FIG. 4 is a diagram of an example of an R-DAC, according to aspects of the disclosure;
FIG. 5 is a diagram of an example of a sensor, according to aspects of the disclosure;
FIG. 6 is a diagram of an example of a sensor, according to aspects of the disclosure;
FIG. 7 is a diagram of an example of a sensor, according to aspects of the disclosure;
FIG. 8 is a diagram of an example of a sensing element, according to aspects of the disclosure;
FIG. 9 is a diagram of an example of a sensing unit, according to aspects of the disclosure;
FIG. 10, is a diagram of an example of a sensing element, according to aspects of the disclosure;
FIG. 11A, is a diagram of an example of a sensing unit, according to aspects of the disclosure; and
FIG. 11B is a diagram of an example of a sensing unit, according to aspects of the disclosure.

DETAILED DESCRIPTION

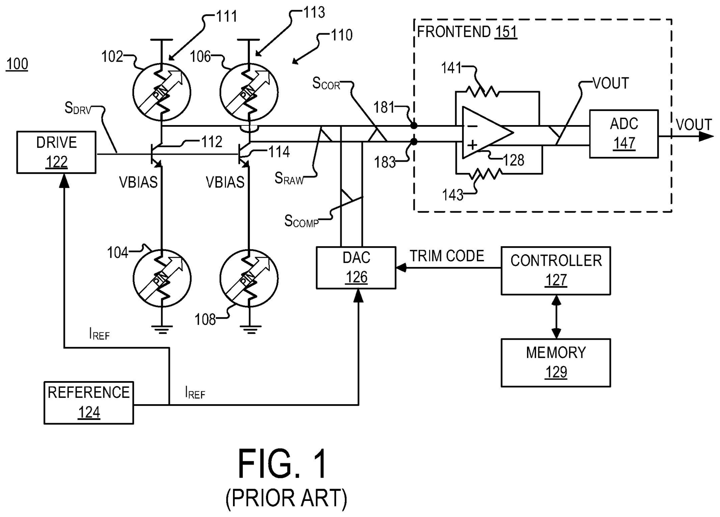

FIG. 1 is a diagram of a magnetic field sensor 100, according to the prior art. The sensor 100 may be any suitable type of magnetic field sensor, such as a position sensor, a current sensor, or a speed sensor. The sensor 100 may be configured to output a signal VOUT that is indicative of the magnitude of a magnetic field that is incident on sensor 100 and/or the value of a quantity that is being measured. By way of example, the signal VOUT may be indicative of the speed of a target, the position of a target, the level of electrical current through a conductor, and/or any other suitable type of quantity.

In the example of FIG. 1, the sensor 100 includes a sensing bridge 110, a driver circuit 122, a reference circuit 124, a digital-to-analog converter (DAC) 126, a frontend 151, a controller 127, and a memory 129. Reference circuit 124 may include any suitable type of circuitry that is arranged to generate a reference signal $I_{REF}$. The driver circuit 122 may include any suitable type of circuitry that is configured to set the voltage at the respective bases of transistors 112 and 114. The frontend 151 may include resistors 141 and 143, an amplifier 128, and an analog-to-digital converter (ADC) 147. The frontend 151 may include input terminals 181 and 183. Input terminal 181 may be coupled to a first input terminal of amplifier 128 and input terminal 183 may be coupled to a second input terminal of amplifier 128. The amplifier 128 may be a current amplifier. However, the present disclosure is not limited to using any specific type of amplifier. For example, in some implementations, amplifier 128 may be a voltage amplifier or a transconductance amplifier. Each of resistors 141 and 143 may be configured to form a different respective feedback loop around amplifier 128. Controller 127 may include one or more of digital logic, a general-purpose processor, a special-purpose processor, an application-specific circuit, and/or any other suitable type of processing circuitry. Memory 129 may include any suitable type of volatile or non-volatile memory, such as a random-access memory (RAM) or flash memory, for example.

The structure of sensing bridge 110 is now described in further detail. As illustrated, sensing bridge 110 may include sensing elements 102, 104, 106, and 108, and transistors 112 and 114. According to the present example, each of sensing elements 102, 104, 106, and 108 is a tunnelling magnetoresistance (TMR) element. However, alternative implementations are possible in which each of sensing elements is a different type of magnetoresistor, such as a giant magnetoresistance (GMR) sensing element. The present disclosure is not limited to using any specific type of magnetoresistor to implement sensing bridge 110. According to the present example, each of the transistors 112 and 114 is a bipolar junction transistor (BJT). However, alternative implementations are possible in which each of transistors 112 and 114 is a different type of transistor, such as a metal-oxide-semiconductor field-effect transistor (MOSFET). It will be understood that the present disclosure is not limited to using any specific transistor to implement sensing bridge 110.

The topology of sensing bridge 110 is now described in further detail. As illustrated, sensing element 102 may be coupled to the collector of transistor 112, sensing element 104 may be coupled to the emitter of transistor 112, and driver circuit 122 may be coupled to the base of transistor 112. Similarly, sensing element 106 may be coupled to the collector of transistor 114, sensing element 108 may be coupled to the emitter of transistor 114, and driver circuit 122 may be coupled to the base of transistor 114. In the example of FIG. 1, sensing elements 102 and 104, and transistor 112 are part of a leg 111 of sensing bridge 110 and sensing elements 106 and 108 and transistor 114 are part of a leg 113 of sensing bridge 110. According to the present example, sensing bridge 110 is an H-bridge. However, the present disclosure is not limited to any specific topology of sensing bridge 110.

As can be readily appreciated, when transistor 112 is a MOSFET, the gate of the transistor may be coupled to driver circuit 122, the drain of the transistor may be coupled to sensing element 102, and the source of the transistor may be coupled to sensing element 104. Similarly, when transistor 114 is a MOSFET, the gate of the transistor may be coupled to the driver circuit 122, the drain of the transistor may be coupled to sensing element 106, and the source of the transistor may be coupled to sensing element 108.

The operation of sensor 100 is now described in further detail. As illustrated, reference circuit 124 may provide a signal $I_{REF}$ to each of the driver circuit 122 and the DAC 126. The driver circuit 122 may apply a signal $S_{DRV}$ at the base of each of transistors 112 and 114. The sensing bridge 110 may generate a signal $S_{RAW}$ in response to a magnetic field that is sensed by sensing bridge 110. The DAC 126 may receive a trim code from controller 127 and convert the trim code to an analog compensation signal $S_{COMP}$. The signal $S_{COMP}$ may be added to the signal $S_{RAW}$ to produce a corrected signal $S_{COR}$. The amplifier 128 may amplify the signal $S_{COR}$ to produce the signal VOUT. The ADC 147 may digitize the signal VOUT and provide it to external circuitry.

The voltage at the emitter of transistor 112 is herein referred to as "biasing voltage of transistor 112" and is denoted using the label "VBIAS." The voltage at the emitter of transistor 114 is herein referred to as "biasing voltage of transistor 114" and is denoted using the label "VBIAS." The difference between the biasing voltage of transistor 112 and the biasing voltage of transistor 114 is herein referred to as $\Delta$VBIAS.

A description is now provided of a challenge associated with the operation of sensing bridge 110. Due to manufacturing tolerances or for other reasons, sensing bridge 110 may end up being unbalanced. When sensing bridge 110 is unbalanced, the respective resistance of at least two sensing elements in sensing bridge 110 would be different when they are subjected to the same identical magnetic field. When the sensing bridge 110 is unbalanced, the signal $S_{RAW}$ may contain noise, which is manifested in an offset being present in signal $S_{RAW}$, and which can diminish the overall accuracy of sensor 100.

The function of DAC 126 is now described in further detail. Specifically, DAC 126 is provided to remove any offset that may be present in signal $S_{RAW}$ due to sensing bridge 110 being unbalanced. The signal $S_{COMP}$ that is generated by DAC 126 is an analog version of a trim code that is fed to DAC 126 by controller 127. In the simplest implementation of sensor 100, the trim code may be stored at the factory in memory 129, from where it can be retrieved (by controller 127) and applied at the input of DAC 126. Alternatively, the trim code may be generated dynamically by controller 127 using any suitable method that is known in the art. It will be understood that the present disclosure is not limited to any specific method for generating and/or obtaining the trim code.

The trim code may represent an opposite (and ideally equal) contribution to any offset that might be present in the signal $S_{RAW}$. Adding the signal $S_{COMP}$ to signal $S_{RAW}$ to produce corrected signal $S_{COR}$ results in the offset that is present in signal $S_{RAW}$ being reduced (or ideally eliminated).

Consider now an example in which the DAC 126 is removed from the sensor 100 or is otherwise disabled. In this example, signal $S_{COMP}$ is equal to zero or is not added at all to the signal $S_{RAW}$. In this example, the offset that would be present in signal VOUT can be described by equations 1-3 below:

$$I_{out} = I_{BIAS} \cdot S_{xMR} \cdot B_{DIFF} = \frac{V_{BIAS}}{R_{xMR}} \cdot S_{xMR} \cdot B_{DIFF} \qquad (1)$$

$$V_{out} = I_{out} \cdot R_{FE} \qquad (2)$$

$$\text{offset} = R_{FE} \cdot \frac{V_{BIAS}}{R_{xMR}} \cdot S_{xMR} \cdot B_{DIFF} \cdot \frac{\Delta \text{VBIAS}}{\text{VBIAS}} = V_{out} \cdot \frac{\Delta \text{VBIAS}}{\text{VBIAS}} \quad (3)$$

where, $I_{out}$ is the differential current out of the sensing bridge 110 which is sensed by the amplifier 128, $I_{BIAS}$ is the biasing current through each of the sensing elements 102-108, obtained by applying the biasing voltage $V_{BIAS}$ to the respective resistance $R_{xMR}$ of any of the sensing elements 102-108, $S_{xMR}$ is the sensitivity of each of the sensing elements 102-108 (measured in ppm/Gauss), $B_{DIFF}$ is the differential magnetic field, that is the difference on the magnetic field applied to legs 111 and 113 of the sensing bridge 110, $V_{out}$ is the value of signal VOUT, and RFE is the trans-resistance of the amplifier 128. Equations 1-3 illustrate that when the sensing bridge 110 is unbalanced, ΔVBIAS would be different from zero, which in turn would result in an offset being present in sensing bridge 110.

A second issue comes from the ADC 147 which digitizes the signal VOUT. For applications that require a high signal-to-noise ratio, ADC 147 can become a bottleneck in noise performance. Furthermore, applications that require front-end distortion to be minimized impose an upper limit on how much trans-resistance (how much gain) can be implemented on the front-end to stop the front-end from clipping. Having offset on the front-end becomes the limiting factor on how much gain can be used, if one is to prevent clipping. A large offset would force a reduction in front-end gain. The lower the front-end gain, the higher the ADC noise. This means that large offsets result in lower gain and larger ADC noise, eventually limiting overall noise performance.

Mathematically, the noise contributions from the sensing bridge 110 and ADC 147 can be expressed (in Gauss) by equation 4 below:

$$\sigma_{GAUSS}^2 = \sigma_{xMR}^2 + \frac{\sigma_{ADC}^2}{FE_{GAIN}^2} \qquad (4)$$

where $\sigma_{GAUSS}$ is the integrated noise referred to the magnetic input for the frontend 151, $\sigma_{xMR}$ is the contribution due to the sensing bridge 110 (expressed in Gauss), $\sigma_{ADC}$ is the contribution from the ADC, usually expressed in Volts at the ADC input, and $FE_{GAIN}$ is the combined gain of the sensing bridge 110 and frontend 151 (expressed in Volts/Gauss). Equation 4 illustrates that the ADC noise contribution increases, the value of $FE_{GAIN}$ rises.

Consider now an example, in which the DAC 126 is enabled. In this example, signal $S_{COMP}$ is ideally equal to the amount of offset that is present in signal $S_{RAW}$. In this example, the offset that would be present in signal VOUT can be described by equations 5-7 below:

$$V_{out} = R_{FE} \cdot \frac{V_{BIAS}}{R_{xMR}} \cdot S_{xMR} \cdot B_{DIFF} + R_{FE} \cdot I_{REF} \cdot TRIM \approx 0 \qquad (5)$$

$$\text{offset} = R_{FE} \cdot \frac{V_{BIAS}}{R_{xMR}} \cdot S_{xMR} \cdot B_{DIFF} \cdot \frac{\Delta V_{BIAS}}{V_{BIAS}} + R_{FE} \cdot I_{REF} \cdot TRIM \cdot \frac{\Delta I_{REF}}{I_{REF}} \quad (6)$$

$$\text{offset} = R_{FE} \cdot \frac{V_{BIAS}}{R_{xMR}} \cdot S_{xMR} \cdot B_{DIFF} \cdot \left[ \frac{\Delta V_{BIAS}}{V_{BIAS}} - \frac{\Delta I_{REF}}{I_{REF}} \right] \neq 0 \quad (7)$$

Equations 5-7 contain the same terms as equations 1-3. Also, equations 5-7 contain two additional terms that are not present in equations 1-3. The additional terms are $I_{REF}$ and TRIM, where $I_{REF}$ is the reference that feeds the DAC 126 to produce its output, and TRIM is the decimal value of the trim code that is input into DAC 126 by controller 127. According to equations 5-7, when the trim code is adjusted and VOUT becomes close to zero, variations on either the bias voltage VBIAS or the DAC's reference $I_{REF}$ would produce variations on the output voltage Vout (*i.e.* variations on the signal VOUT), no matter how close was the trim code to the offset that is present in the signal $S_{RAW}$.

In more technical terms, a drawback of the topology shown in FIG. 1 is the lack of correlation between the reference used for sensing bridge 110 (VBIAS) and the reference used for the DAC 126 ($I_{REF}$). On top of that, the sensing bridge 110 and the DAC 126 are subject to different disturbances, such as different supply rejection. This means that certain noise on the supply would couple through both the sensing bridge 110 and the DAC 126 in different ways, increasing front-end output noise and not cancelling out.

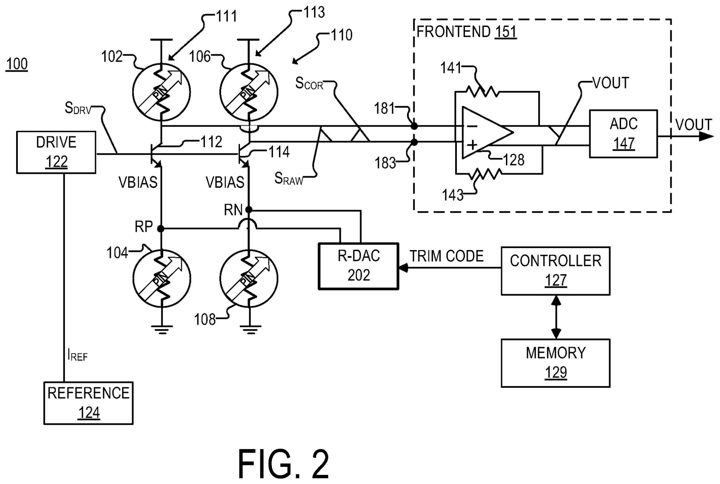

FIG. 2 is a diagram of an improved implementation of sensor 100 which addresses the above drawbacks. The implementation of sensor 100 that is shown in FIG. 2 is nearly identical to the implementation shown in FIG. 1, except for a couple of differences. Specifically, in the implementation of FIG. 2, DAC 126 is replaced with a resistive DAC 202 (hereinafter "R-DAC) which is coupled to the respective emitters of transistors 112 and 114. Specifically, a terminal RP of R-DAC 202 may be coupled between the emitter of transistor 112 and sensing element 104. Similarly, a terminal RN of R-DAC 202 may be coupled between the emitter of transistor 114 and sensing element 108. In the example of FIG. 2, R-DAC 202 does not receive a reference signal from the reference circuit 124.

The working principle of the example of FIG. 2 is that the original unbalance of sensing bridge 110 is the result of legs 111 and 113 of sensing bridge 110 having different respective resistances. By adding the R-DAC 202 in parallel with legs 111 and 113, the unbalance is compensated for in a way that does not worsen noise performance. Once the R-DAC 202 is adjusted (*i.e.,* based on the trim code provided by controller 127), legs 111 and 113 of sensing bridge 110 would ideally show equal resistance. This in turn results in improved supply (and reference) rejection. In particular, the variations and noise in the biasing of sensing bridge 110 would translate into a much smaller amount of output variation and noise (in comparison to the architecture of FIG. 1). Furthermore, unlike the DAC 126 (shown in FIG. 1), the R-DAC 202 needs no reference signal in order to work correctly, which eliminates the noise source injected through that path, as well.

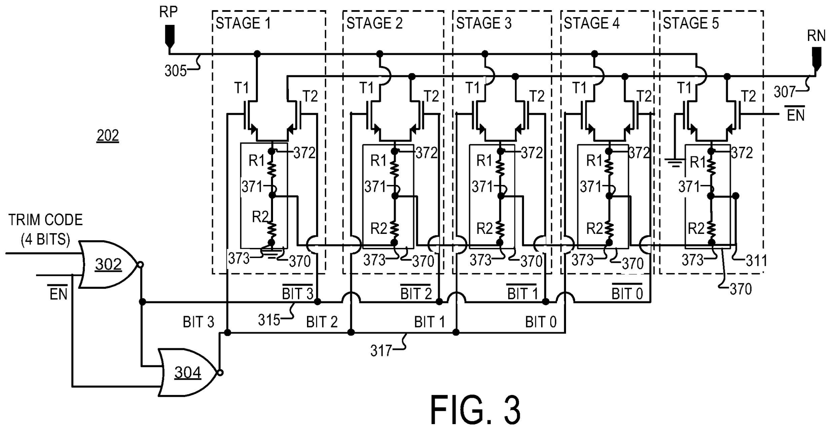

FIG. 3 is a diagram of an example of one implementation of the R-DAC 202, according to aspects of the disclosure. As illustrated, R-DAC 202 may include terminals RP and RN, a plurality of NOR gates 302, lines 305 and 307, buses 315 and 317, a plurality of NOR gates 304, and a plurality of stages that are herein enumerated as stages 1-5.

Each of stages 1-5 may include respective transistors T1 and T2, and respective resistors R1 and R2. The resistors R1 and R2 in each of stages 1-5 are configured to implement a respective voltage divider 370. The transistors T1 and T2 of each of stages 1-5 are arranged to implement a switch that is configured to toggle the voltage divider that is part of the same stage between: (1) being disconnected from line 307 and being coupled to line 305, and (2) being disconnected from line 305 and being coupled to line 307. Each of the switches may be configured to operate based on the value of a different bit that is part of the trim code (shown in FIG. 2). For example, when bit 3 of the trim code is set to '1', transistors T1 and T2 of stage 1 may couple the voltage divider 370 of stage 1 to line 305. On the other hand, when bit 3 of the trim code is set to '0', transistors T1 and T2 of stage 1 may couple the voltage divider 370 of stage 1 to line 307. As another example, when bit 2 of the trim code is set to '1', transistors T1 and T2 of stage 2 may couple the voltage divider 370 of stage 1 to line 305, and when bit 2 is set to '0', transistors T1 and T2 of stage 2 may couple the voltage divider 370 of stage 2 to line 307.

Each of voltage dividers 370 may include end terminals 372 and 373 and an output terminal 371. By way of example, an end terminal of a voltage divider may be a terminal that is situated to the side of all resistors that make up the voltage divider, and an output terminal of the voltage divider may be a terminal that is situated between two of the resistors that make up the voltage divider. As used herein, the term "terminal" refers to a point of electrical contact. The usage of the term "terminal" does not necessarily imply the provision of a pin or a contact pad, soldering, and/or any other special accommodations for creating an electrical connection. For example, the conductive trace that connects resistors R1 and R2 of stage 1 may be integral with the conductive trace that branches from the output terminal 371 of stage 1 to the end terminal 373 of stage 2.

According to the present example, each of the transistors T1 and T2, in any of stages 1-5, is a BJT. However, alternative implementations are possible in which at least one of transistors T1 and T2, in any of stages 1-5, is a different type of transistor, such as MOSFET. It will be understood that the present disclosure is not limited to using any specific type of transistor to implement stages 1-5. According to the example of FIG. 3, the collector of transistor T1 in each of stages 1-5 is coupled to line 305, the collector of transistor T2 in each of stages 1-5 is coupled to line 307, the emitters of transistors T1 and T2 in each of the stages 1-5 are coupled to each other, and resistor R1 of that stage. The respective base of transistor T1 in each of stages 1-5 is coupled to bus 317, and the respective base of transistor T2 in each of stages 1-5 is coupled to bus 315.

In the present example, NOR gates 302 and 304 are configured to receive the trim code (also shown in FIG. 2) and an enable signal. According to the present example, the trim code is 4 bits wide, and each of the NOR gates 302 is configured to receive a different bit of the trim code and the enable signal. Similarly, each of NOR gates 304 is configured to receive a different bit of the trim code and the enable signal. According to the present example, each of NOR gates 302 is configured to output the complement of a different one of the bits in the trim code on a respective one of the lines that make up bus 315. Similarly, each of the NOR gates 304 is configured to output a different one of the bits in the trim code on a respective one of the lines that make up bus 317.

According to the present example, bus 315 is configured to: (i) apply the complement of bit 3 of the trim code at the base of transistor T2 of stage 1, (ii) apply the complement of bit 2 of the trim code at the base of transistor T2 of stage 2, (iii) apply the complement of bit 1 of the trim code at the base of transistor T2 of stage 3, and (iv) apply the complement of bit 0 at the base of transistor T2 of stage 4. Similarly, bus 317 is configured to: (i) apply bit 3 of the trim code at the base of transistor T1 of stage 1, (ii) apply bit 2 of the trim code at the base of transistor T1 of stage 2, (iii) apply bit 1 of the trim code at the base of transistor T1 of stage 3, and (iv) apply bit 0 at the base of transistor T1 of stage 4.

Line 305 spans between terminal RP and the collector of transistor T1 of stage 5, line 307 spans between terminal RN and the collector of transistor T1 of stage 1. The base of transistor T1 of stage 5 is coupled to ground and the base of transistor T2 of stage 5 is arranged to receive the enable signal. A bypass line 311 is formed around resistor R2 of stage 5, which is configured to short-circuit the output terminal 371 of stage 5 with the end terminal 373 of stage 5.

In the example of FIG. 3, output terminal 371 of stage 1 is coupled to end terminal 373 of stage 2. The output terminal 371 of stage 2 is coupled to end terminal 373 of stage 3. The output terminal 371 of stage 3 is coupled to end terminal 373 of stage 4. The output terminal 371 of stage 4 is coupled to end terminal 373 of stage 5. The output terminal 371 of stage 5 is shorted with the end terminal 373 of stage 5. The phrase "terminal of stage X" shall mean "terminal of the voltage divider 370 that is part of stage X". In the example of FIG. 3, the number of stages in R-DAC 202 may be equal to the number of bits in the trim code. Under the nomenclature of the disclosure, stages that have the topology of stages 1-4 are referred to as intermediate stages and stages that have the topology of stage 5 are referred to as a final stage. In general, for a trim code containing n bits, there may be n-1 intermediate stages and 1 final stage, where n is a positive integer greater than 1. The output terminal of each intermediate stage may be connected to one of the end terminals of the next stage in the sequence, and the output terminal of the last stage in the sequence may be shorted with the end terminal of the last stage. The present disclosure is not limited to the trim code having any specific bit width.

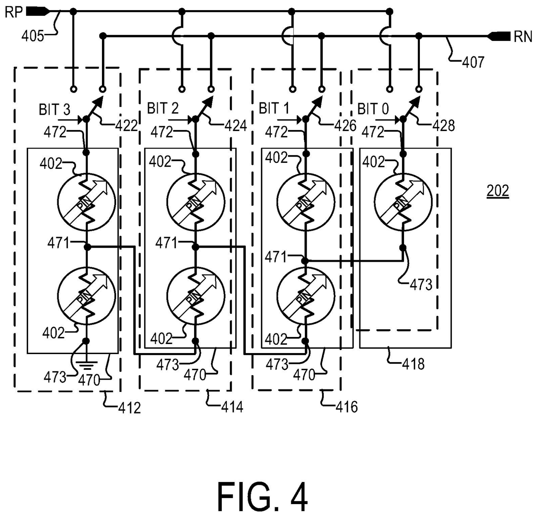

FIG. 4 is a diagram of an example of another implementation of the R-DAC 202, according to aspects of the disclosure. In the example of FIG. 4, R-DAC 202 includes a plurality of MR elements 402 that are arranged in stages 412, 414, 416, and 418, respectively. Furthermore, R-DAC 202 includes lines 405 and 407, as well as switches 422, 424, 426, and 428. Line 405 is coupled to terminal RP of R-DAC 202, and line 407 is coupled to terminal RN of R-DAC 202. The MR elements 402 in each of stages 412, 414, and 416 may be configured to form a respective voltage divider 470. In the example of FIG. 4, the respective voltage divider 470 of each of stages 412-416 consists entirely of MR elements. However, one or more of the MR elements 402 in any of stages 412-416 may be replaced with a fixed resistor, for as long as the voltage divider 470 that is part of that stage includes at least one MR element as one of its resistive components. Furthermore, in some implementations, the respective voltage dividers 470 of one or more of the stages 412-416 may be implemented by using entirely fixed resistors, for as long as at least one of stages 412-418 includes at least one MR element.

The switches 422-428 are arranged to receive the trim code (shown in FIG. 2) and toggle each of the stages 412-418 between being coupled to line 405 and being coupled to line 407. According to the example of FIG. 4, the trim code is 4-bits wide. In this regard, switch 422 may be arranged to receive bit 3 of the trim code. When bit 3 is set to a first value (*e.g.,* '1'), switch 422 may couple the voltage divider 470 that is part of stage 412 to line 405; and when bit 3 is set to a second value (*e.g.*, '0'), switch 422 may couple the voltage divider 470 that is part of stage 412 to line 407. Switch 424 may be arranged to receive bit 2 of the trim code. When bit 2 is set to a first value (*e.g.,* '1'), switch 424 may couple the voltage divider that is part of stage 414 to line 405; and when bit 2 is set to a second value (*e.g.*, '0'), switch 424 may couple the voltage divider 470 that is part of stage 414 to line 407. Switch 426 may be arranged to receive bit 1 of the trim code. When bit 1 is set to a first value (*e.g.,* '1'), switch 426 may couple the voltage divider 470 that is part of stage 416 to line 405; and when bit 1 is set to a second value (*e.g.,* '0'), switch 426 may couple the voltage divider 470 of stage 416 to line 407. Switch 428 may be arranged to receive bit 0 of the trim code. When bit 0 is set to a first value (*e.g.*, '1'), switch 428 may couple the MR element 402 that is part of stage 418 to line 405; and when bit 0 is set to a second value (*e.g.*, '0'), switch 428 may couple the MR element 402 that is part of stage 418 to line 407.

The respective voltage divider 470 of each of stages 412, 414, and 416 may include an output terminal 471, an end terminal 473, and an end terminal 472. End terminal 472 of stage 412 may be coupled to switch 422. End terminal 472 of stage 414 may be coupled to switch 424. End terminal 472 of stage 416 may be coupled to switch 426. Furthermore, MR element 402 of stage 418 may be coupled to switch 428, as shown. End terminal 473 of stage 412 may be coupled to ground. Output terminal 471 of stage 412 may be coupled to end terminal 473 of stage 414. Output terminal 471 of stage 414 may be coupled to end terminal 473 of stage 416. Output terminal 471 of stage 416 may be coupled to MR element 402 of stage 418, as shown.

In the example of FIG. 4, the number of stages in R-DAC 202 may be equal to the number of bits in the trim code. Under the nomenclature of the present disclosure, stages having the topology of stages 412-416 are referred to as "intermediate stages" and stages having the topology of stage 418 are referred to as a "final stage". For a trim code containing n bits, there may be n-1 intermediate stages and 1 final stage, where n is a positive integer greater than 1. The output terminal of each intermediate stage may be connected to one of the end terminals of the next stage in the sequence.

The present disclosure is not limited to the trim code having any specific bit width.

In some respects, implementations in which the R-DAC 202 is arranged to include one or more MR elements are advantageous because this permits better tracking or process variation and temperature variations in the elements in sensing bridge 110. This allows better control over the trim accuracy and thus relaxes the requirements that are placed on the R-DAC 202 (e.g., it decreases the number of bits that need to be present in the trim code and/or the number of stages that need to be present in the R-DAC 202). In this regard, it will be understood that, in some embodiments, each (or at least one) of the MR elements that are used to implement the R-DAC 202 may have the same or similar configuration to the MR elements used to implement any of the sensing elements 102-108 in the sensing bridge 110, so that the MR elements in sensing bridge 110 would drift in the same way with temperature as would the sensing elements 402.

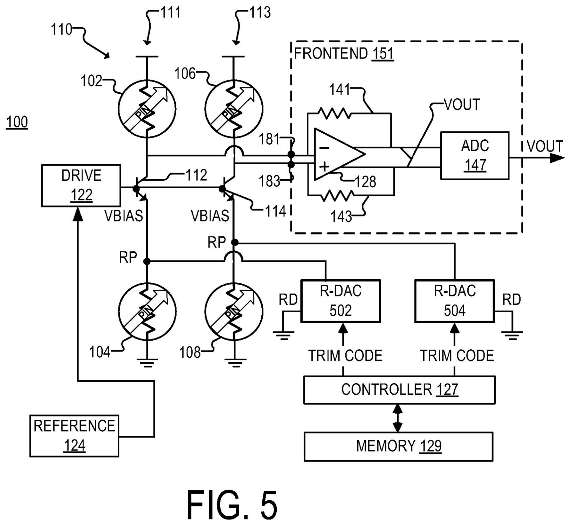

FIG. 5 is a diagram of another implementation of the sensor 100, according to aspects of the disclosure. The implementation of sensor 100 shown in FIG. 5 is identical to the implementation shown in FIG. 2, but for the R-DAC 202 being replaced with R-DACs 502 and 504. Each of R-DACs 502 and 504 is the same or similar to R-DAC 202 (shown in FIG. 2). The RP terminal of R-DAC 502 is coupled to the emitter of transistor 112, and the RD terminal of R-DAC 502 is coupled to ground. The RD terminal of R-DAC 504 is coupled to the emitter of transistor 114, and the RD terminal of R-DAC 504 is coupled to ground. FIG. 5 is provided to illustrate that the resistance of sensing bridge 110 can be balanced by adjusting the resistance of each of legs 111 and 113 with a different R-DAC. According to the present example, both R-DACs 502 and 504 are fed the same trim code by controller 127. However, alternative implementations are possible in which R-DAC 502 and 504 are provided with different trim codes by controller 127.

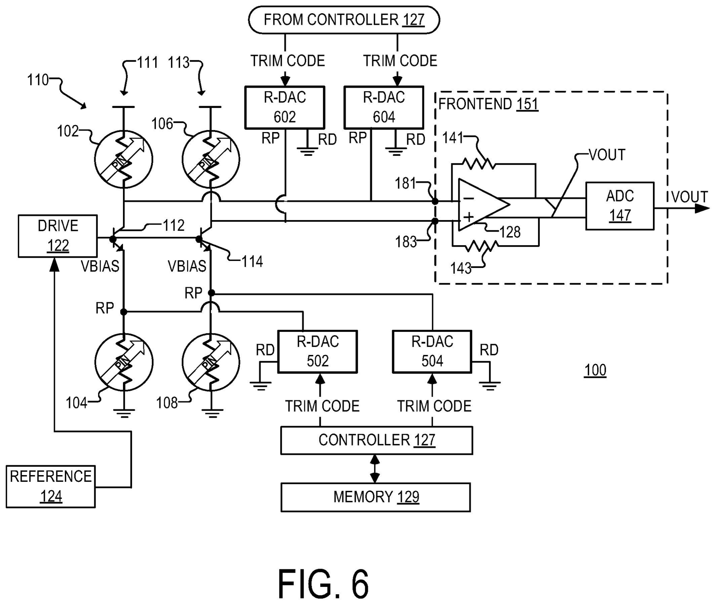

FIG. 6 is a diagram of another implementation of the sensor 100, according to aspects of the disclosure. The implementation of sensor 100 shown in FIG. 6 is identical to the implementation shown in FIG. 5, but for including R-DACs 602 and 604, in addition to the R-DACs that are present in the example of FIG. 5. The RP terminal of R-DAC 602 is coupled to the collector of transistor 112, and the RD terminal of R-DAC 602 is coupled to ground. The RD terminal of R-DAC 604 is coupled to the collector of transistor 114, and the RD terminal of R-DAC 504 is coupled to ground. FIG. 6 is provided to illustrate that the resistance of sensing bridge 110 can be balanced by adjusting the resistance of each of legs 111 and 113 with a different pair of R-DACs. According to the present example, all of R-DACs 502, 504, 602, and 604 are fed the same trim code by controller 127. However, alternative implementations are possible in which at least two of R-DACs 502, 504, 602, and 604 are provided with different trim codes by controller 127.

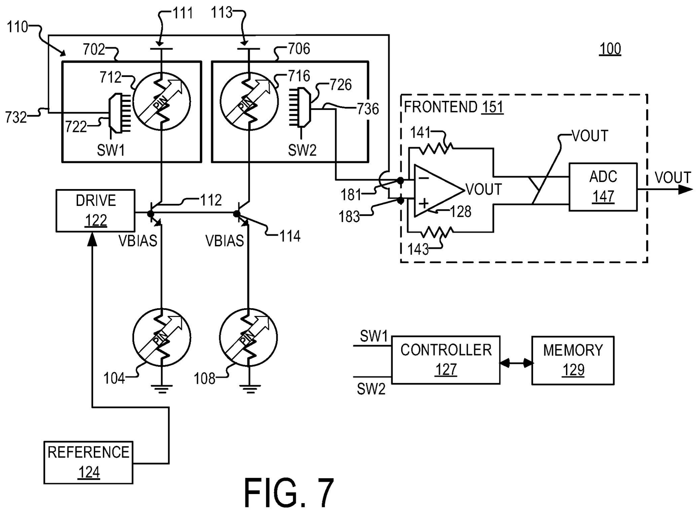

FIG. 7 is a diagram of another implementation of the sensor 100, according to aspects of the disclosure. The implementation of sensor 100 that is shown in FIG. 7 is identical to the implementation shown in FIG. 2, but for the R-DAC 202 being removed and sensing elements 102 and 106 being replaced with sensing units 702 and 706.

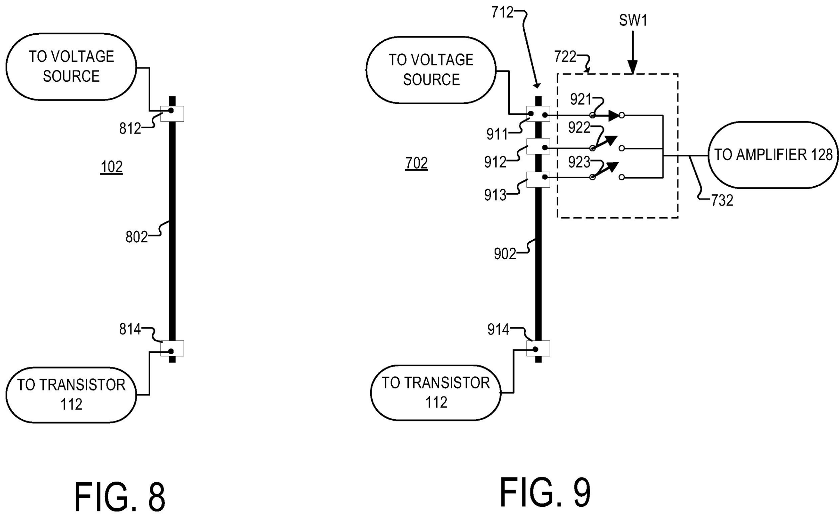

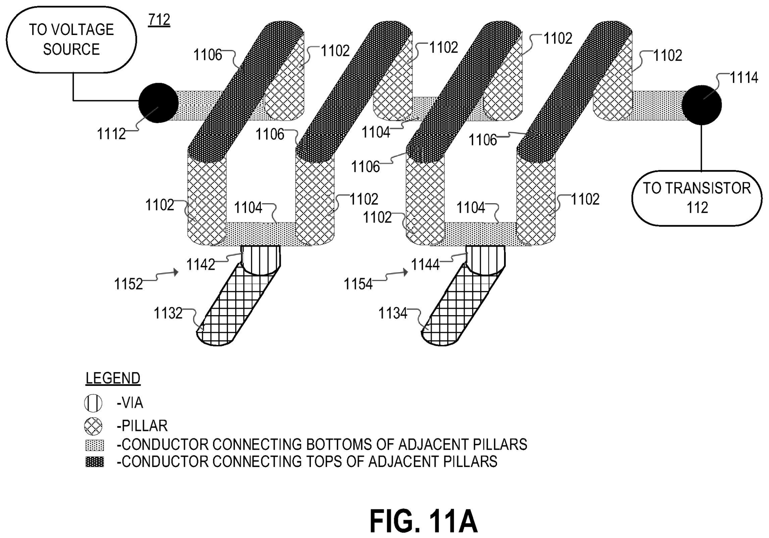

Sensing unit 702 is used to replace sensing element 102 (shown in FIG. 2) and it performs the same function as sensing element 102 -- i.e., it provides a resistance that varies with an incident magnetic field. Sensing unit 702 includes a sensing element 712 and a switching circuitry 722. In some implementations, sensing element 712 may be implemented in the manner discussed further below with respect to FIGS. 8-11B. Switching circuitry may include an output terminal 732 that is coupled to one of the input terminals of amplifier 128. Switching circuitry may be configured to tap at different tap points in sensing element 712. Depending on the tap point that is tapped into, the resistance of sensing element 712 may be increased or decreased. For example, if the resistance of sensing element 108 is lower than the nominal resistance of sensing element 712, the switching circuitry 722 may equalize the resistance of sensing unit 702 with that of sensing element 108 by tapping into a tap point that corresponds to a lower resistance. In the example of FIG. 9, the nominal resistance of sensing element 712 is the resistance between tap points 911-914, and in the example of FIG. 11A, the nominal resistance of sensing element 712 is the resistance that develops between tap points 1112-1114.

In some respects, sensing element 712 (or sensing element 716) may be thought of as behaving as a voltage divider (that is, acting as a string of resistors). In this regard, depending on the tap point, the fraction of the output voltage readout changes. Moreover, there exists a respective tap point for sensing unit 712 and/or sensing unit 716 where the output of sensing bridge 110 is nulled (when no magnetic field is being applied to sensing bridge 110). This tap point (or set of tap points) is the one that cancels out any offset that might otherwise be present in the output of sensing bridge 110. Accordingly, sensing unit 712 and/or sensing unit 716 may be set to these tap points. In one respect, the method illustrated by FIG. 7 is advantageous because it avoids the use of a separate R-DAC, which in turn results in better tracking over temperature or other environmental conditions, for example.

The tap point that is tapped into by switching circuitry 722 is selected based on a signal SW1. Signal SW1 is provided to switching circuitry 722 by controller 127. In the simplest implementation of sensor 100, the value of signal SW1 may be stored in memory 129 at the factory (as a result of performing factory calibration on sensor 100), after which the value of signal SW1 can be retrieved from memory 129 by controller 127, and fed to switching circuitry 722 by controller 127. Alternatively, in some implementations, the value of signal SW1 may be selected dynamically by controller 127.

Sensing unit 706 is used to replace sensing element 106 (shown in FIG. 2) and it performs the same function as sensing element 106-- i.e., it provides a resistance that varies with an incident magnetic field. Sensing unit 706 includes a sensing element 716 and a switching circuitry 726. In some implementations, sensing element 716 may be implemented in the manner discussed further below with respect to FIGS. 8-11B. Switching circuitry 726 may include an output terminal 736 that is coupled to another one of the input terminals of amplifier 128. Switching circuitry may be configured to tap at different tap points in sensing element 716. Depending on the tap point that is tapped into, the resistance of sensing element 716 may be increased or decreased. For example, if the resistance of sensing element 104 is lower than the nominal resistance of sensing element 716, the switching circuitry 726 may equalize the resistance of sensing unit 706 with that of sensing element 104 by tapping into a tap point that corresponds to a lower resistance. It can be readily appreciated that, if sensing units 702 and 706 are operated together, they may work together to remove the contributions (to offset) of both sensing elements 104 and 108, rather than sensing unit 702 balancing out sensing element 108 specifically and sensing unit 706 specifically balancing sensing element 104.

The tap point that is tapped into by switching circuitry 726 is selected based on a signal SW2. Signal SW2 is provided to switching circuitry 726 by controller 127. In the simplest implementation of sensor 100, the value of signal SW2 may be stored in memory 129 at the factory (as a result of performing factory calibration on sensor 100), after which the value of signal SW2 can be retrieved from memory 129 by controller 127, and fed to switching circuitry 726 by controller 127. Alternatively, in some implementations, the value of signal SW2 may be selected dynamically by controller 127. Stated succinctly, the present disclosure is not limited to any specific method for generating switching signals SW1 and SW2. In some implementations, the values of signals SW1 and SW2 may be selected to ensure that leg 111 has the same resistance as leg 113 when no magnetic fields are incident on sensing bridge 110 and/or when legs 111 and leg 113 are exposed to an identical magnetic field. As noted above, if equalizing the respective resistances legs 111 and 113 does not yield offset cancelation in a particular application, signals SW1 and SW2 may be set to respective values which result in the offset in the output of sensing bridge 110 being nulled when no magnetic fields are present. These values may be determined at the factory, as a result of executing a calibration procedure.

In the example of FIG. 7, the signal VOUT is a differential signal that is output by the switching circuitry 722 and 726. As in the example of FIG. 2, the signal VOUT is indicative of the magnitude of the magnetic field(s) that are incident on sensing bridge 110 and/or a quantity that is measured by sensor 100, such as the position of a target, the speed of a target, or the level of electrical current that is flowing through a conductor.

FIG. 8 is a diagram of one possible implementations of sensing element 102, according to aspects of the disclosure. In this example, sensing element is implemented as a TMR yoke 802 having tap points 812 and 814. In the circuit that is shown in FIG. 2, tap point 812 may be coupled to the voltage source, and tap point 814 may be coupled to the collector of transistor 112. The resistance of sensing element 102 is proportional to the distance between tap points 812 and 814 and other physical characteristics of TMR yoke 802. The resistance of sensing element 102 may vary in response to the magnetic field that is incident on the TMR yoke 802. Although in the example of FIG. 8, yoke 812 is a TMR yoke, alternative implementations are possible in which yoke 802 is a different type of magnetoresistance (MR) yoke, such as a GMR yoke.

FIG. 9 is a diagram of an example of the sensing unit 702, according to aspects of the disclosure. In the example of FIG. 9, sensing element 712 is implemented as a TMR yoke 902 having tap points 911, 912, 913, and 914.

Switching circuitry 722 may include a plurality of switches 921-923. When signal SW1 is a multi-bit signal, each of switches 921-923 may be turned on and off in accordance with a different bit of signal SW1. For example, when bit 0 of signal SW1 is set to '0', switch 921 may be open, and when bit 0 of signal SW1 is set to '1', switch 921 may be closed. When bit 1 of signal SW1 is set to '0', switch 922 may be open, and when bit 1 of signal SW1 is set to '1', switch 922 may be closed. And when bit 2 of signal SW1 is set to '0', switch 922 may be open, and when bit 1 of signal SW1 is set to '1', switch 922 may be closed. In some implementations, signal SW1 may be configured in such a way so that only one of the bits in signal SW1 is set to '1' and/or only one of the switches in switching circuitry 722 is closed at any given time.

In the circuit shown in FIG. 7, tap point 914 may be coupled to the collector of transistor 112, and tap point 911 may be coupled to the voltage source. Each of tap points 911-913 may be coupled to switching circuitry 722. In one specific implementation, switching circuitry 722 may be arranged to connect one and only one of tap points 911-913 to amplifier 128. The resistance of sensing element 712 (and/or leg 111 of sensing bridge 110) which is registered at amplifier 128 may depend on the tap point that is coupled to amplifier 128, and it may be proportional to the distance between tap point 914 and one of tap points 911-913 that is coupled to the amplifier 128. For example, when tap point 911 is coupled to amplifier 128 (while tap points 912 and 913 are disconnected from amplifier 128), amplifier 128 may sense a first resistance; when tap point 912 is coupled to amplifier 128 (while tap points 911 and 913 are disconnected from amplifier 128), amplifier 128 may sense a second resistance that is smaller than the first resistance; and when tap point 913 is coupled to amplifier 128 (while tap points 911 and 912 are disconnected from amplifier 128), amplifier 128 may sense a third resistance that is smaller than the second resistance.

Under the nomenclature of the present disclosure, tap points 911 and 914 are referred to as "end tap points" and tap points 912 and 913 are referred to as "intermediate tap points". Tap points 911 and 914 are coupled to opposite ends of the TMR yoke 902, and tap points 911 and 912 are coupled to locations in the TMR yoke 902 that are situated between the ends of the TMR yoke 902, where tap points 911 and 914 are coupled. Although, in the example of FIG. 9, the sensing element 712 includes two intermediate tap points, it will be understood that sensing element 712 may include any number of tap points. Although the example of FIG. 9 is provided in the context of sensing unit 702, it will be understood that sensing unit 706 may be configured in the same manner.

Although in the example of FIG. 9, yoke 912 is a TMR yoke, alternative implementations are possible in which yoke 902 is a different type of magnetoresistance (MR) yoke, such as a GMR yoke.

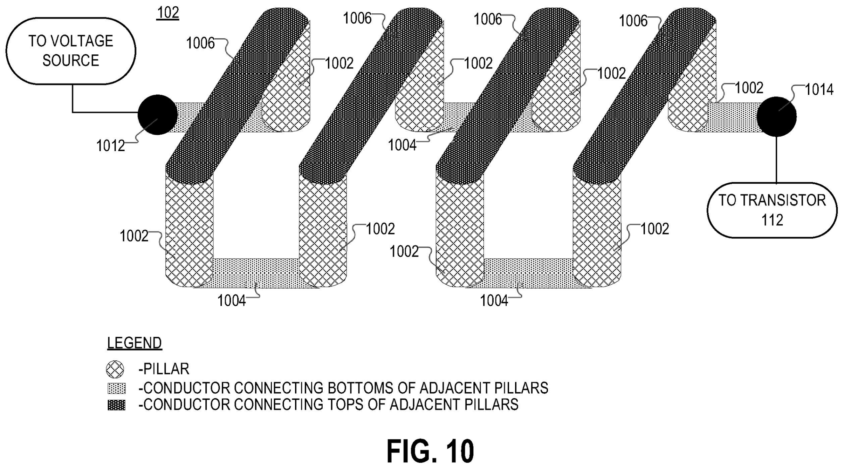

FIG. 10 is a diagram of an example of sensing element 102, according to the aspects of the disclosure. In this example, sensing element 102 is implemented as a series of TMR pillars 1002. The tops of some of the TMR pillars 1002 may be connected with top conductors 1006, as shown. The bottoms of some of the TMR pillars 1002 may be connected by bottom conductors 1004. The top conductors 1006, the bottom conductors 1004, and the TMR pillars 1002 may be formed on a substrate (not shown), such as a silicon die. The bottom conductors 1004 may be disposed closer to the substrate than the top conductor. The TMR pillars 1002 may extend away from the bottom conductors 1004 (and/or the substrate) in a direction that is substantially perpendicular to a main surface of the substrate. Sensing element 102 may include a tap point 1012 that is coupled to one end of the series of TMR pillars 1002 and a tap point 1014 that is coupled to the other end of the TMR pillars 1002. When sensing element 102 is integrated into the circuit shown in FIG. 2, tap point 1012 may be coupled to the voltage source and tap point 1014 may be coupled to the collector of transistor 112.

FIG. 11A is a diagram of an example of sensing element 712, according to one possible implementation. In this example, sensing element is implemented as a series of TMR pillars 1102. The tops of some of the TMR pillars 1102 may be connected with top conductors 1106, as shown. The bottoms of some of the TMR pillars 1102 may be connected by bottom conductors 1104. The top conductors 1106, the bottom conductors 1104, and the TMR pillars 1102 may be formed on a substrate (not shown), such as a silicon die. The bottom conductors 1104 may be disposed closer to the substrate than the top conductor. The TMR pillars 1102 may extend away from the bottom conductors 1104 (and/or the substrate) in a direction that is substantially perpendicular to a main surface of the substrate.

Sensing element 712 may include a tap point 1112 that is coupled to one end of the series of TMR pillars 1002 and a tap point 1014 that is coupled to the other end of the TMR pillars 1002. When sensing element 102 is integrated into the circuit shown in FIG. 7, tap point 1012 may be coupled to the voltage source, and tap point 1014 may be coupled to the collector of transistor 112.

Sensing element 712 is further provided with tap points 1152 and 1154. Tap point 1152 may include a via 1142 and a conductor 1132. The via 1142 may extend from one of the bottom conductors 1104 to the conductor 1132. Tap point 1154 may include a via 1142 and a conductor 1134. The via 1142 may extend from another one of the bottom conductors 1104 to the conductor 1134.

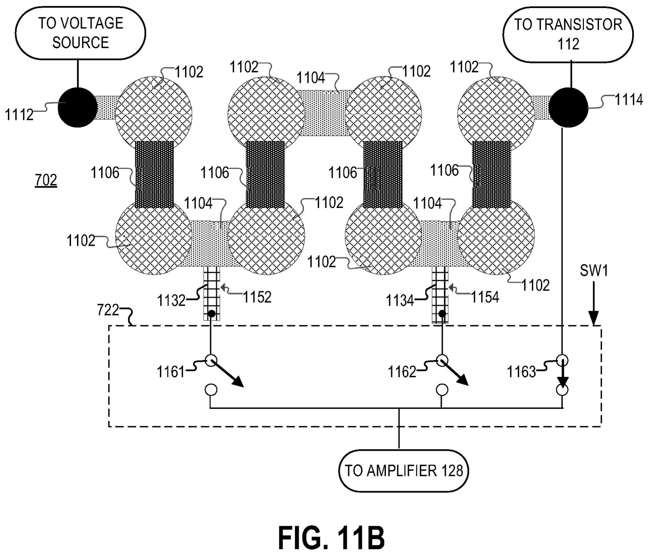

FIG. 11B shows an example of the sensing unit 702, according to aspects of the disclosure. In the example of FIG. 11B, switching circuitry 722 may include a plurality of switches 1161-1163. When signal SW1 is a multi-bit signal, each of switches 1161-1163 may be turned on and off in accordance with a different bit of signal SW1. For example, when bit 0 of signal SW1 is set to '0', switch 1161 may be open, and when bit 0 of signal SW1 is set to '1', switch 1161 may be closed. When bit 1 of signal SW1 is set to '0', switch 1162 may be open, and when bit 1 of signal SW1 is set to '1', switch 1162 may be closed. When bit 2 of signal SW1 is set to '0', switch 1162 may be open, and when bit 1 of signal SW1 is set to '1', switch 1162 may be closed. In some implementations, signal SW1 may be configured in such a way so that only one of the bits in signal SW1 is set to '1' and/or only one of the switches in switching circuitry 722 is closed at any given time.

In the circuit shown in FIG. 7, tap point 1112 may be coupled to the voltage source, and tap point 1114 may be coupled to the collector of transistor 112 and to switch 1163 of switching circuitry 722. Conductor 1132 of tap point 1152 may be coupled to switch 1161 of switching circuitry 722, and conductor 1134 of tap point 1154 may be coupled to switch 1162. Switching circuitry 722 may be arranged to connect one and only one of tap points 1152, 1154, and 1114 to amplifier 128. The resistance of sensing element 712 (and/or leg 111 of sensing bridge 110) which is registered at amplifier 128 may depend on the tap point that is coupled to amplifier 128, and it may be proportional to the distance between tap point 914 and one of tap points 911-913 that is coupled to the amplifier 128. For example, when tap point 1114 is coupled to amplifier 128 (while tap points 1152 and 1154 are disconnected from amplifier 128), amplifier 128 may sense a first resistance; when tap point 1154 is coupled to amplifier 128 (while tap points 1114 and 1152 are disconnected from amplifier 128), amplifier 128 may sense a second resistance that is smaller than the first resistance; and when tap point 1152 is coupled to amplifier 128 (while tap points 1114 and 1154 are disconnected from amplifier 128), amplifier 128 may sense a third resistance that is smaller than the second resistance.

Under the nomenclature of the present disclosure, tap points 1112 and 1114 are referred to as "end tap points" and tap points 1152 and 1154 are referred to as "intermediate tap points". Tap points 1112 and 1114 are coupled to opposite ends of the serial circuit that is shown in FIG. 11A, and tap points 1152 and 1144 are coupled to locations that are situated between the opposite ends. Although tap points 1152 and 1154 are coupled to bottom conductors 1104 in the example of FIG. 11A, alternative implementations are possible in which at least one of tap points 1152 and 1154 is coupled to one of top conductors 1106. Although, in the example of FIG. 11A, sensing element 712 includes two intermediate tap points, it will be understood that sensing element 712 may include any number of tap points. Although the example of FIG. 11A is provided in the context of sensing unit 702, it will be understood that sensing unit 706 may also be implemented in the same manner. Although, in the example of FIGS. 11A-B, the TMR pillars 102 are arranged in a serial circuit, in alternative implementations they may be arranged in a parallel circuit. For example, two or more of the pillars 102 may be coupled in parallel with each other and/or the sensing element 712 may include parallel connections of TMR pillars. Although in the example, of FIGS. 11A-B, sensing element 712 is implemented by using TMR pillars, in alternative implementations sensing element 712 may include a different type of MR element in place of the TMR pillars.

A magnetic-field sensing element can be, but is not limited to, a Hall Effect element a magnetoresistance element, or an inductive coil. As is known, there are different types of Hall Effect elements, for example, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb). The phrase "set of magnetic field elements" shall mean "one or more magnetic field sensing elements".

The concepts and ideas described herein may be implemented, at least in part, via a computer program product, (e.g., in a non-transitory machine-readable storage medium such as, for example, a non-transitory computer-readable medium), for execution by, or to control the operation of, data processing apparatus (e.g., a programmable processor, a computer, or multiple computers). Each such program may be implemented in a high-level procedural or object-oriented programming language to work with the rest of the computerbased system. However, the programs may be implemented in assembly, machine language, or Hardware Description Language. The language may be a compiled or an interpreted language, and it may be deployed in any form, including as a stand-alone program or as a module, component, subroutine, or another unit suitable for use in a computing environment. A computer program may be deployed to be executed on one computer or multiple computers at one site or distributed across multiple sites and interconnected by a communication network. A computer program may be stored on a non-transitory machine-readable medium that is readable by a general or special-purpose programmable computer for configuring and operating the computer when the non-transitory machine-readable medium is read by the computer to perform the processes described herein. For example, the processes described herein may also be implemented as a non-transitory machine-readable storage medium, configured with a computer program, where upon execution, instructions in the computer program cause the computer to operate in accordance with the processes. A non-transitory machine-readable medium may include but is not limited to a hard drive, compact disc, flash memory, non-volatile memory, or volatile memory. The term unit *(e.g.,* an addition unit, a multiplication unit, *etc.*), as used throughout the disclosure may refer to hardware (e.g., an electronic circuit) that is configured to perform a function *(e.g.,* addition or multiplication, *etc.*), software that is executed by at least one processor, and configured to perform the function, or a combination of hardware and software.

Also, for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard.

Having described preferred embodiments, which serve to illustrate various concepts, structures and techniques, which are the subject of this patent, it will now become apparent that other embodiments incorporating these concepts, structures and techniques may be used. Accordingly, it is submitted that the scope of the patent should not be limited to the described embodiments but rather should be limited only by the spirit and scope of the following claims.

## Claims

1.   A sensor comprising:

a sensing bridge including a first leg and a second leg, the first leg including a first magnetoresistance (MR) element that is coupled to a second MR element via a first transistor, the second leg including a third MR element that is coupled to a fourth MR element via a second transistor;
a frontend circuit having a first input and a second input, the first input being coupled to the first leg, and the second input being coupled to the second leg; and
a first resistive digital-to-analog converter (R-DAC) that is coupled to at least the first leg, the first R-DAC being arranged to receive a first trim code and modify a first resistance of the first leg based on the first trim code.

2. The sensor of claim 1, wherein the first R-DAC is coupled to both the first leg and the second leg of the sensing bridge.

3. The sensor of claim 1, wherein the first R-DAC includes:

   a first R-DAC terminal;
   a second R-DAC terminal; and
   a sequence of stages, each stage including a voltage divider and a respective switch, the respective switch of each of the stages being configured to toggle the respective voltage divider of the stage, based on a corresponding bit of the first trim code, between being coupled to the first R-DAC terminal and being coupled to the second R-DAC terminal, the respective voltage divider of each of the stages, except for a last stage in the sequence, having an output terminal that is coupled a respective end terminal of a next stage in the sequence.

4. The sensor of claim 3, wherein the respective voltage divider of the last stage in the sequence includes an output terminal that is shorted with an end terminal of the respective voltage divider of the last stage in the sequence.

5. The sensor of claim 1, wherein the first R-DAC includes:

   a first R-DAC terminal;
   a second R-DAC terminal; and
   a sequence of stages including a plurality of initial stages and a final stage, each of the initial stages including a respective switch and a respective voltage divider whereby the respective voltage dividers of one or more of the initial stages is implemented by using at least one MR element, the respective switch of each of the initial stages in the sequence being configured to toggle the respective voltage divider of the initial stage, based on a corresponding bit of the first trim code, between being coupled to the first R-DAC terminal and being coupled to the second R-DAC terminal, the respective voltage divider of each of the initial stages having an output terminal that is coupled to a respective end terminal of a next stage in the sequence, the next stage in the sequence being either another one of the initial stages or the final stage.

6. The sensor of claim 1, further comprising a second R-DAC that is coupled to the second leg, the second R-DAC being arranged to receive a second trim code and modify a second resistance of the second leg based on the second trim code.

7. The sensor of claim 1, further comprising a second R-DAC that is coupled to the first leg, the second R-DAC being arranged to receive a second trim code and further adjust the first resistance of the first leg based on the second trim code.

8. The sensor of claim 6 or 7, wherein the second trim code is different from the first trim code.

9. The sensor of claim 1, further comprising a controller that is configured to provide the first trim code to the first R-DAC.

10. The sensor of claim 1, further comprising:

    a second R-DAC that is coupled to the first leg, the second R-DAC being arranged to receive a second trim code and further adjust the first resistance of the first leg based on the second trim code;
    a third R-DAC that is coupled to the second leg, the third R-DAC being arranged to receive a third trim code and adjust a second resistance of the second leg based on the third trim code; and
    a fourth R-DAC that is coupled to the second leg, the fourth R-DAC being arranged to receive a fourth trim code and further adjust the second resistance of the second leg based on the fourth trim code.

11. The sensor of claim 1, wherein the frontend circuit is configured to receive a sensing signal that is at least in part generated by the sensing bridge in response to a magnetic field that is incident on the sensing bridge, and generate an output signal based on the sensing signal.

12. The sensor of claim 1, wherein the output signal is indicative of one of: (i) a position of a target, (ii) a speed of a target, and (iii) a level of electrical current that is flowing through a conductor.

13. The sensor of claim 1, wherein each of the first, second, third, and fourth MR elements includes one of a giant magnetoresistance (GMR) element or a tunneling magnetoresistance (TMR) element.

14. A sensor comprising:

a sensing bridge including a first leg and a second leg, the first leg including a first switching circuitry, a first transistor, a first magnetoresistance (MR) element, and a second MR element that is coupled to the first MR element via the first transistor, the second leg including a third MR element that is coupled to a fourth MR element via a second transistor; and
a frontend circuit having a first input and a second input, the first input being coupled to the first leg, and the second input being coupled to the second leg,
wherein the first MR element includes a plurality of first tap points, the plurality of first tap points including a pair of first end tap points and one or more first intermediate tap points;
wherein one of the first end tap points is coupled to one of a power source or ground, and the other one of the first end tap points is coupled to the other one of the power source and ground,
wherein the first switching circuitry includes a plurality of switches, each of the switches being configured to toggle a different one of the plurality of first tap points between being coupled to the frontend circuit and being disconnected from the frontend circuit, and
wherein the first switching circuitry is configured to receive a first trim code and adjust a resistance of the first MR element that is sensed at the frontend circuit based on the first trim code.

15. The sensor of claim 14, wherein the first MR element includes a magnetoresistance (MR) yoke having a yoke body, the first end tap points being coupled to end locations in the yoke body and the first intermediate tap points being coupled to locations in the yoke body that are situated between the end locations in the yoke body.

16. The sensor of claim 14, wherein the first MR element includes a plurality of TMR pillars that are arranged in a serial circuit, the first end tap points being coupled to opposite ends of the serial circuit, and the first intermediate tap points being coupled to locations in the serial circuit that are situated between the ends of the serial circuit.

17. The sensor of claim 16, wherein each of the plurality of first tap points is coupled to a different one of a plurality of bottom conductors, each of the plurality of bottom conductors being arranged to couple a different respective one of the plurality of TMR pillars to a corresponding one of the plurality of TMR pillars.

18. The sensor of claim 16, wherein each of the plurality of switches is configured to toggle a different one of the plurality of first tap points, except for one of the first end tap points, between being coupled to the frontend circuit and being disconnected from the frontend circuit.

19. The sensor of claim 14, further comprising a controller that is configured to generate the first trim code.

20. The sensor of claim 1 or 14, wherein:

the first transistor is a binary junction transistor having a first collector that is coupled to the first MR element and a first emitter that is coupled to the second MR element;
the second transistor is a binary junction transistor having a second collector that is coupled to the third MR element and a second emitter that is coupled to the fourth MR element.

21. The sensor of claim 1 or 14, wherein:

the first transistor is a metal-oxide field-effect transistor (MOSFET) having a first drain that is coupled to the first MR element and a first source that is coupled to the second MR element;
the second transistor is a MOSFET having a second drain that is coupled to the third MR element and a second source that is coupled to the fourth MR element.

22. The sensor of claim 1 or 14, wherein the frontend circuit includes an amplifier, wherein a first input of the amplifier is coupled to the first leg of the sensing bridge and a second input of the amplifier is coupled to the second leg of the sensing bridge.

23. The sensor of claim 1 or 14, further comprising a driving circuit that is coupled to a first control terminal of the first transistor and a second control terminal of the second transistor.

24. The sensor of claim 14, wherein:

the second leg further includes a second switching circuitry,

wherein the third MR element includes a plurality of second tap points, the plurality of second tap points including a pair of second end tap points and one or more second intermediate tap points;

wherein one of the second end tap points is coupled to one of a power source or ground, and the other one of the second end tap points is coupled to the other one of the power source and ground,

wherein the second switching circuitry includes a plurality of switches, each of the switches being configured to toggle a different one of the plurality of second tap points between being coupled to the frontend circuit and being disconnected from the frontend circuit, and

wherein the second switching circuitry is configured to receive a second trim code and adjust a resistance of the third MR element that is sensed at the frontend circuit based on the second trim code.

FIG. 1

(PRIOR ART)

EP 4 768 978 A1

FIG. 2

FIG. 3

FIG. 4

FIG. 5

EP 4 768 978 A1

FIG. 6

FIG. 7

EP 4 768 978 A1

TO AMPLIFIER 128

732

SW1

722

712

TO VOLTAGE SOURCE

921
922
923

911
912
913

902

914

702

TO TRANSISTOR 112

**FIG. 9**

TO VOLTAGE SOURCE

812

102

802

814

TO TRANSISTOR 112

**FIG. 8**

FIG. 10

LEGEND

⊗ -PILLAR
▦ -CONDUCTOR CONNECTING BOTTOMS OF ADJACENT PILLARS
▩ -CONDUCTOR CONNECTING TOPS OF ADJACENT PILLARS

TO VOLTAGE SOURCE

712

1106  1102  1102  1102  1102

1114

1112

1106  1104  1106

TO TRANSISTOR 112

1102  1104  1102  1106  1102  1102  1104  1102

1142  1144

1152  1154

1132  1134

LEGEND

◍ -VIA

⊗ -PILLAR

▦ -CONDUCTOR CONNECTING BOTTOMS OF ADJACENT PILLARS

◼ -CONDUCTOR CONNECTING TOPS OF ADJACENT PILLARS

**FIG. 11A**

EP 4 768 978 A1

FIG. 11B

**EUROPEAN SEARCH REPORT**

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/041511 A1 (ROMERO HERNÁN D [AR] ET AL) 11 February 2021 (2021-02-11) | 14-24 | INV. G01R33/00 G01R33/09 |
| A | * abstract * <br> * paragraph [0034] - paragraph [0039]; figures 2,5,6,9 * <br> * paragraph [0046] - paragraph [0055] * <br> * paragraph [0059] - paragraph [0060] * <br> ----- | 1-13 | |
| A | JP 2015 177205 A (YAMAHA CORP) 5 October 2015 (2015-10-05) <br> * abstract; figures 1-3 * <br> * paragraph [0019] - paragraph [0032] * <br> ----- | 1-13 | |
| A | SARKAR SAYAN: "Novel Strategies for DAC based Offset Elimination Technique in Resistive Bridge Sensor", <br> TENCON 2022 - 2022 IEEE REGION 10 CONFERENCE (TENCON) IEEE, <br> 1 November 2022 (2022-11-01), pages 1-6, XP034250282, <br> DOI: 10.1109/TENCON55691.2022.9977718 <br> [retrieved on 2022-12-20] <br> * the whole document * <br> ----- | 1-13 | |
| A | US 2013/342273 A1 (PETRIE CRAIG S [US]) 26 December 2013 (2013-12-26) <br> * abstract * <br> * paragraph [0039] - paragraph [0053]; figure 3 * <br> ----- | 1-13 | |
| A | US 5 168 244 A (MURANAKA MASAMI [JP]) 1 December 1992 (1992-12-01) <br> * First embodiment; figure 2 * <br> ----- | 1,14 | |

**TECHNICAL FIELDS SEARCHED (IPC)**

G01R

The present search report has been drawn up for all claims

| Place of search | Date of completion of the search | Examiner |
|---|---|---|
| Munich | 4 May 2026 | Warneck, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 8700

This annex lists the patent family members relating to the patent documents cited in the above-mentioned European search report.
The members are as contained in the European Patent Office EDP file on
The European Patent Office is in no way liable for these particulars which are merely given for the purpose of information.

04-05-2026

| Patent document cited in search report | Publication date | Patent family member(s) | | Publication date |
|---|---|---|---|---|
| US 2021041511 A1 | 11-02-2021 | NONE | | |
| JP 2015177205 A | 05-10-2015 | NONE | | |
| US 2013342273 A1 | 26-12-2013 | EP | 2845316 A2 | 11-03-2015 |
| | | JP | 6198823 B2 | 20-09-2017 |
| | | JP | 2015521828 A | 30-07-2015 |
| | | KR | 20150034692 A | 03-04-2015 |
| | | US | 2013342273 A1 | 26-12-2013 |
| | | WO | 2014004002 A2 | 03-01-2014 |
| US 5168244 A | 01-12-1992 | JP | 2682270 B2 | 26-11-1997 |
| | | JP | H04369878 A | 22-12-1992 |
| | | US | 5168244 A | 01-12-1992 |

EPO FORM P0459

For more details about this annex : see Official Journal of the European Patent Office, No. 12/82